# EUROPÄISCHE PATENTSCHRIFT

(11) **EP 0 362 644 B1**
(45) Veröffentlichungstag und Bekanntmachung des Hinweises auf die Patenterteilung: **26.05.1993**
(21) Anmeldenummer: 89117607.5
(22) Anmeldetag: 23.09.1989
(51) Int. Cl.: C08G 73/10, C08G 73/06, G03F 7/038, C08L 79/08, C08L 79/04

(54) **Strahlungsempfindliche Gemische und deren Verwendung**
Radiation-sensitive compositions and their use
Compositions sensibles aux radiations et leur utilisation

(30) Priorität: 01.10.1988 DE 3833437
(43) Veröffentlichungstag der Anmeldung: 11.04.1990
(73) Patentinhaber: BASF Aktiengesellschaft, 67063 Ludwigshafen (DE)
(72) Erfinder: Blum, Rainer, D-6700 Ludwigshafen (DE); Rehmer, Gerd, Dr., D-6711 Beindersheim (DE); Schupp, Hans, Dr., D-6520 Worms 1 (DE)

(56) Entgegenhaltungen:
- EP-A- 0 027 506
- EP-A- 0 178 500

## Beschreibung

Die Erfindung betrifft strahlungsempfindliche Gemische die oligomere oder polymere, in Gegenwart geeigneter Initiatoren durch Strahlung, vorzugsweise UV-Strahlung, in ihrer Löslichkeit veränderliche Vorstufen von Polyimiden, Polyisoindolochinazolindionen, Polyoxazindionen, Polychinazolindionen, Polychinazolonen und verwandten Polyheterocyclen enthalten, Verfahren zu deren Herstellung und deren Verwendung.

Es ist bekannt, strukturierte Schichten, insbesondere für den Aufbau elektronischer Schaltungen, dadurch zu erzeugen, daß zunächst lösliche, strahlungsempfindliche, bevorzugt UV-empfindliche Vorstufen (A) aus Lösung auf das Substrat aufgetragen und unter milden Bedingungen getrocknet werden. Unter einer Maske wird dann mit Strahlen einer geeigneten Wellenlänge eine entsprechend der Maske strukturierte vernetzte Zwischenstufe (B) gebildet. Mit geeigneten Lösemitteln werden die nicht bestrahlten, d.h. unbelichteten Stellen, die noch die Vorstufe (A) enthalten, ausgewaschen. Die aus den stehengebliebenen Stellen gebildete Struktur kann schließlich unter Anwendung hoher Temperaturen in die Endfunktionsstruktur der Stufe (C) überführt werden.

Für die Herstellung von Strukturen die, z.B. bei der Herstellung oder dem Gebrauch von Schaltkreisen der Mikroelektronik, hohen thermischen und mechanischen Belastungen ausgesetzt sind, werden als Stoffe der Funktionsstufe (C) bevorzugt die oben erwähnten heterocyclischen bzw. aromatisch-heterocyclischen Polymeren verwendet.

Die löslichen Vorstufen (A) für solche Polymeren (C) sind im allgemeinen von polyamidischer Grundstruktur und zwar so, daß in Nachbarschaft zur Amidgruppe eine andere Gruppe steht, in der Regel eine Carboxyl-, Ester-oder Ethergruppe, die bei der Überführung in die Stufe (C) unter Anwendung höherer Temperaturen mit der Amidgruppe eine Kondensationsreaktion eingeht.

Es sind zwei Wege bekannt, polyamidische Grundstrukturen der Stufe (A) strahlenvernetzbar zu machen.
1. Die direkte Vernetzung an der Polymergrundkette, wobei vom Benzophenon oder dem Benzophenon strukturähnlichen Carbonylverbindungen ausgegangen wird, die an der Carbonylgruppe, in Gegenwart geeigneter Photoinitiatoren, mit UV-Licht vernetzen. Solche Systeme sind z.B. in EP-A-01 34 752, EP-A-01 81 837, EP-A-01 62 017 und US-A-4 568 601 beschrieben.
2. Die Vernetzung über Seitenketten mit olefinisch ungesättigten Gruppen und die Herstellung hierfür geeigneter Vorstufen, wie sie z.B. in DE-A-24 37 397, DE-A-24 37 348, DE-A-24 37 413, DE-A-24 37 369, DE-A-29 19 840, DE-A-29 19 841, DE-A-29 33 826, DE-A-23 08 830 beschrieben wird.
   Vorstufen der genannten Art, die in organischen Lösungsmitteln löslich sind, sind beispielsweise aus der DE-PS 23 08 830 bekannt. Die bekannten polymeren Vorstufen sind Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren. Die strahlungsempfindliche Reste tragenden Verbindungen enthalten zwei für Additions- oder Kondensationsreaktionen geeignete Carboxyl-, Carbonsäurechlorid-, Amino-, Isocyanat- oder Hydroxylgruppen und teilweise in ortho- oder para-Stellung dazu esterartig an Carboxylgruppen gebundene ethylenisch ungesättigten Gruppen. Die mit diesen Verbindungen umzusetzenden Diamine, Diisocyanate, Bis-säurechloride und Dicarbonsäuren weisen mindestens ein cyclisches Strukturelement auf.
   Strahlungsreaktive Polyimid-Vorstufen werden dabei insbesondere in der Weise hergestellt, daß ungesättigte Alkohole, wie Allylalkohol, an Tetracarbonsäuredianhydride, wie Pyromellithsäuredianhydrid, addiert, die freien Carbonsäuregruppen der dabei gebildeten Diester in Säurechloridgruppen übergeführt und die entstandenen Diester-bis-säurechloride einer Polykondensationsreaktion mit einem - meist aromatischen - Diamin, wie Diaminodiphenyläther, unterworfen werden. Bei der Verwendung von Diaminoverbindungen, die ortho-ständige Amidogruppen aufweisen, entstehen in entsprechender Weise Polyisoindolochinazolindione.
   Polyoxazindion-Vorstufen entstehen durch Polyaddition von Diisocyanaten, wie Diphenylmethandiisocyanat, an phenolische Hydroxylgruppen olefinisch ungesättigter Diester, wie Methylen-disalicylsäureester, und - in entsprechender Weise - Polychinazolindione durch Polyaddition von Diisocyanaten am Aminogruppen olefinisch ungesättigter Diester.
   Die bekannten Herstellungsverfahren erfordern im allgemeinen mehrere Reaktionsschritte und auch tiefe Temperaturen. Darüber hinaus ist bei der Verwendung von Säurechloriden eine intensive Reinigung der Reaktionsprodukte erforderlich, d.h. die Synthese von ungesättigten Diestern der genannten Art ist schwierig durchzuführen.
   In DE-A-2 933 826 wird ein Weg aufgezeigt, durch Addition von ungesättigten Epoxiden an carboxylgruppentragende Vorstufen, einen Teil dieser Schwierigkeiten zu umgehen. Nachteilig ist dabei, daß Carboxylgruppen nur bei höherer Temperatur und mit Katalysatoren in befriedigender Geschwindigkeit mit Epoxidgruppen reagieren. Dies führt dazu, daß häufig unlösliche, z.B. durch Teilimidisierung, oder anvernetzte Produkte entstehen.
   Nachteile dieses Prinzips sind also die Schwierigkeiten beim Aufbau der Stufen (A), die sich aus dem ungesättigten Charakter der Ausgangs- und der Endstoffe ergeben.
   Es dürfen z.B. nur relativ niedrige Temperaturen angewandt werden, was lange Reaktionszeiten und schlechte Umsätze ergibt. Weiter müssen trotzdem z.T. Polymerisationsinhibitoren bei der Herstellung zugegeben und später in aufwendigen Reinigungsschritten wieder entfernt werden, um bei der Verwendung eine hohe Lichtempfindlichkeit zu erreichen.
   Ein anderer Nachteil ergibt sich bei der Aufbewahrung und Verarbeitung der ungesättigten Stufen (A), die wegen der Gefahren der Oxidation und Polymerisation, unter Inertgas und Kühlung erfolgen müssen.

Aufgabe der vorliegenden Erfindung ist es, oligomere und/oder polymere Vorstufen von Polyimiden, Polyisoindolochinazolindionen, Polyoxazindionen, Polychinazolindionen und Polychinazolonen und verwandten Polyheterocyclen bereitzustellen, die in organischen Lösemitteln löslich, strahlungsreaktiv, in einfacher Weise herstellbar und ohne besondere Vorsichtsmaßnahmen, wie Inertgas und Kühlung, aufbewahrbar und verarbeitbar sind.

Diese Aufgabe läßt sich überraschenderweise erfindungsgemäß durch Einführung doppelbindungsfreier, zur leichten Abgabe von Wasserstoff befähigter Reste, im Folgenden als R¹ bezeichnet und näher spezifiert, in die Vorstufen (A), unter Mitverwendung bestimmter Carbonylverbindungen lösen.

Die Reste R¹ in den Vorstufen (A) stehen dabei in geeigneter Stellung zu einer Amidgruppe, so daß sie bei hoher Temperatur mit dieser eine Kondensationsreaktion eingehen und dabei die hochwärmebeständigen Stoffe der Stufe (C) ergeben.

Gegenstand der vorliegenden Erfindung sind zur Herstellung von Polyimiden, Polyisoindolochinazolindionen, Polyoxazindionen, Polychinazolindionen oder Polychinazolonen geeignete strahlungsempfindliche Gemische, die bei Bestrahlung mit aktinischem Licht eine Löslichkeitsdifferenzierung erfahren, die dadurch gekennzeichnet sind, daß die strahlungsempfindlichen Gemische bestehen aus (a) einer oder mehreren Vorstufen, die Strukturelemente der allgemeinen Formel (I) aufweisen, 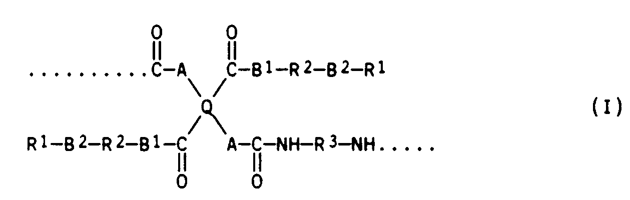
worin
- A =: -O-, -NH- oder eine Einfachbindung,
- Q =: ein aromatischer oder heterocyclischer tetravalenter Rest oder ein zwei über eine Brückengruppe miteinander verbundene bivalente aromatische Reste enthaltender Rest, in dem jeweils zwei der Valenzen in Nachbarstellung zueinander angeordnet sind,
- B¹ =: -O- oder -NR⁴-,
- B² =: -NH-CO-NH-, -NH-CO-O-, -NH-CO- oder eine Einfachbindung,
- R¹ =: ein leicht wasserstoffabgebender Rest,
- R² =: ein bivalenter aliphatischer oder aromatischer Rest oder eine Einfachbindung,
- R³ =: ein bivalenter aliphatischer, cycloaliphatischer, aromatischer oder heterocyclischer Rest, der gegebenenfalls halogensubstituiert ist,
- R⁴ =: H, geradkettiges oder verzweigtes Alkyl, das halogensubstituiert sein kann,
mit der Maßgabe, daß der leicht wasserstoffabgebende Rest R¹ ein Rest aus der Gruppe Isoalkyle, Aminoisoalkyle, Cycloisoalkyle, Cycloisoalkyle mit einem oder mehreren Heteroatomen, oder Gruppierungen folgender allgemeiner Formeln ausgewählt ist 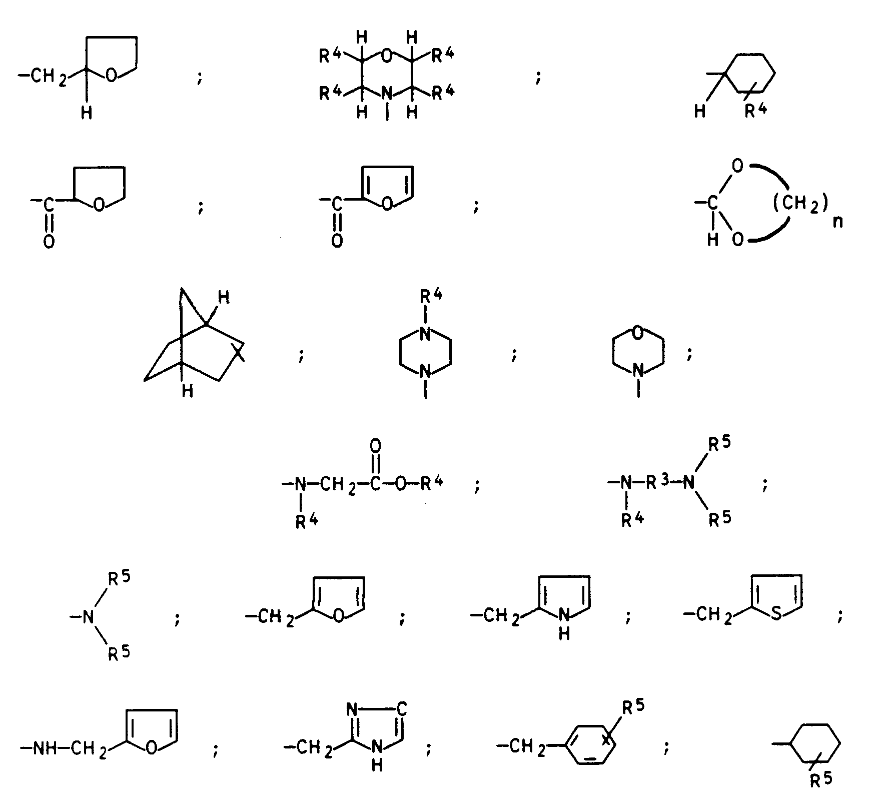
worin
- n: = 2 oder 3 und
- R⁵: = Alkyl, Aryl, halogensubstituiertes Alkyl oder halogen- oder anderweitig substituiertes Aryl;

(b) einer oder mehreren aromatische Reste enthaltenden Carbonylverbindungen, die im durch UV-Strahlung angeregten Zustand zur Wasserstoffabstraktion befähigt sind, sowie gegebenenfalls
(c) einen oder mehreren Stoffen aus der Gruppe Photoinitiator, Photosensibilisator, (Leuko)farbstoff und aliphatisches Keton.

Als aromatische Reste enthaltende Carbonylverbindungen (b) kommen insbesondere solche aus der Gruppe Benzophenon, Xanthon, Thioxanthon, Fluorenon, Benzil, Acenaphthenchinon, Tetralon, Benzylidenaceton, Dibenzylidenacetophenon, Benzoin, Benzoinether, Benzanilid, Acetophenon, Propiophenon, Naphthochinon, Anthrachinon, Anthron und die aus diesen Grundkörpern durch Halogenierung oder Alkylierung abgeleiteten Carbonylverbindungen in Frage.

Ebenso können als Carbonylverbindung (b) Benzophenon und Benzophenonderivate, allein oder im Gemisch mit 2-, 3- und 4-Hydroxibenzophenon, Benzophenon-2-carbonsäure, Benzophenon-3-carbonsäure, Benzophenon-4-carbonsäure, 3,3′,4,4′-Benzophenontetracarbonsäure und deren Anhydrid, 3,3′,4,4′-Tetra-(tert.-butylperoxycarbonyl)-benzophenon, 2-, 3- und 4-Phenylbenzophenon, 2-, 3- und 4-Alkylbenzophenone mit 1 bis 10 C-Atomen im Alkylrest oder halogenierten (Monoalkyl)benzophenonen, wie 4-(Trifluormethyl)-benzophenon sowie Heterocerdianthron und dessen Endoperoxid, oder Ketone wie 2-Acetonaphthon, 4-Aminobenzophenon, Michler's Keton und die Salze dieser Amine sowie gegebenenfalls auch zusätzlich aliphatische Ketone wie Aceton, Methylisobutylketon, Isoamylketon und Copolymerisate von Kohlenmonoxid mit Ethylen eingesetzt werden.

Die erfindungsgemäßen strahlungsempfindlichen Gemische enthalten die Carbonylverbindung (b) im allgemeinen in einer Menge von 0,001 bis 200, vorzugsweise 1 bis 10 Gew.%, bezogen auf die strahlungsempfindliche Vorstufe (a).

In den erfindungsgemäßen strahlungsempfindlichen Gemischen können die Carbonylverbindungen (b) in fester, gelöster, dispergierter oder geschmolzener, monomerer und/oder polymerer Form eingesetzt werden; ferner können zur Verbesserung der Lichtempfindlichkeit bzw. zur Anpassung der Absorption an ein UV-Strahlenquelle zusätzlich nichtcarbonylische Photoinitiatoren, Photosensibilisatoren und/oder bestimmte (Leuko)Farbstoffe zugegeben werden.

Die Vorstufen (a) können in monomerer, oligomerer oder polymerer From oder in Mischungen verschiedener Polymerisationsstufen eingesetzt werden.

Zum Aufbau der Vorstufen (a) können carboxylgruppenhaltige Polyadditionsprodukte aus aromatischen und/oder heterocyclischen Tetracarbonsäureanhydriden und Diaminoverbindungen an den Carboxylgruppen mit Resten R¹ über eine Ester-, Ether-, Amid- oder Urethangruppe verknüpft sein oder carboxylgruppenhaltige Polyadditionsprodukte aus aromatischen und/oder heterocyclischen Dihydroxydicarbonsäuren und Diisocyanaten können an den Carboxylgruppen mit Resten R¹ über eine Ester-, Ether-, Amid- oder Urethangruppe verknüpft sein, oder carboxylgruppenhaltige Polyadditionsprodukte aus aromatischen und/oder heterocyclischen Diaminodicarbonsäuren und Diisocyanaten können an den Carboxylgruppen mit Resten R¹ über eine Ester-, Ether-, Amid- oder Urethangruppe verknüpft sein.

Gegenstand der vorliegenden Erfindung ist auch ein Verfahren zur Herstellung von erfindungsgemäßen strahlungsempfindlichen Gemischen, wobei zur Einführung der Reste R¹ in die Vorstufen (a) carboxylgruppenhaltige Polyadditionsprodukte aus aromatischen und/oder heterocyclischen Diaminodicarbonsäuren und Diisocyanaten und/oder carboxylgruppenhaltige Polyadditionsprodukte aus aromatischen und/oder heterocyclischen Dihydroxydicarbonsäuren und Diisocyanaten und/oder carboxylgruppenhaltige Polyadditionsprodukte aus aromatischen und/oder heterocyclischen Tetracarbonsäureanhydriden und Diaminoverbindungen, mit Monoaddukten von Diisocyanaten mit Verbindungen der Struktur R¹-OH, R¹-NH₂, R¹-(B²)-NH₂ und/oder R¹-COOH umgesetzt werden.

Bevorzugt ist, in die carboxylgruppenhaltigen Polyadditionsprodukte aus aromatischen und/oder heterocyclischen Diaminodicarbonsäuren und Diisocyanaten und/oder carboxylgruppenhaltigen Polyadditionsprodukte aus aromatischen und/oder heterocyclischen Dihydroxydicarbonsäuren und Diisocyanaten und/oder carboxylgruppenhaltigen Polyadditionsprodukte aus aromatischen und/oder heterocyclischen Tetracarbonsäureanhydriden und Diaminoverbindungen, die Reste R¹ in einer solchen Menge einzuführen, daß das Verhältnis der Reste R¹ zu den Carboxylgruppen der carboxylgruppenhaltigen Polyadditionsprodukte 1:1 bis 0,05:1 beträgt.

Dabei werden vorzugsweise als Tetracarbonsäureanhydrid Pyromellitsäureanhydrid und/oder Benzophenontetracarbonsäureanhydrid, als Dihydroxidicarbonsäure 4,4′-Dihydroxydiphenylmethan-3,3′-dicarbonsäure und als Diaminodicarbonsäure 4,4′-Diaminodiphenylmethan-3,3′-dicarbonsäure eingesetzt.

Die erfindungsgemäßen strahlungsempfindlichen Gemische können zusätzlich zu den darin enthaltenen, über Reste R¹ vernetzbaren Gruppierungen weitere strahlungsempfindliche Reste enthalten, insbesondere Reste mit ethylenischen Doppelbindungen und/oder andere Reste, die mit Bisaziden vernetzen.

Die erfindungsgemäßen strahlungsempfindlichen Gemische können auch mit anderen strahlungsempfindlichen Stoffen und/oder nicht strahlungsempfindlichen Stoffen gemischt verwendet werden.

Gegenstand der Erfindung ist auch die Verwendung der erfindungsgemäßen strahlungsempfindlichen Gemische für Lacke, Einbettungsmaterialien und Überzugsmittel sowie zur Erzeugung schützender und isolierender Schichten für die Anwendung beim Aufbau gedruckter Schaltungen und integrierter Schaltkreise, wobei sie einer Strahlenvernetzung und/oder thermischen Nachbehandlung unterzogen werden, oder wobei sie unter einer Maske belichtet und dadurch partiell strahlenvernetzt, danach mit geeigneten Lösemitteln strukturiert und dann gegebenenfalls einer thermischen Nachbehandlung unterzogen werden.

Die erfindungsgemäß einzusetzenden Vorstufen (A) sind in organischen, insbesondere polaren Lösungsmitteln, wie z.B. Formamid, Acetamid, N-Methylformamid, N,N-Dimethylformamid, N-Methylpyrrolidon, N,N-Dimethylacetamid, Butyrolacton, Caprolactam, Hexamethylphosphorsäuretrisamid oder deren Gemischen löslich, einfach herstellbar und ohne Anwendung besonderer Vorsichtsmaßnahmen aufzubewahren und zu verarbeiten, ohne an Strahlungsreaktivität zu verlieren.

Die erfindungsgemäßen strahlungsempfindlichen Gemische, d.h. die Mischung aus (a) den Vorstufen (A) und den Carbonylverbindungen (b), die im durch UV-Strahlung angeregten Zustand der Wasserstoffabstraktion befähigt sind, zeichnen sich besonders durch Ausbildung scharfer Konturen bei der Photostrukturierung und gute Dauerwärmestandfestigkeit der Endfunktionsstruktur aus.

Zu den Aufbaukomponenten der erfindungsgemäßen Vorstufen (A) und der strahlungsreaktiven Gemische ist im einzelnen folgendes auszuführen.

Die erfindungsgemäßen Vorstufen (a) enthalten oder bestehen vorzugsweise aus Gruppierungen der allgemeinen Formel (I) 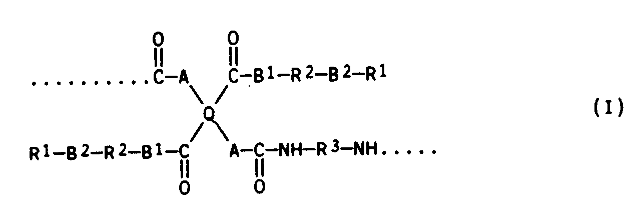
worin
- A =: -O-, -NH- oder eine Einfachbindung,
- Q =: ein gegebenenfalls halogenierter - zumindest partiell aromatischer und/oder heterocyclischer tetravalenter, d.h. tetrafunktioneller Rest, bei dem jeweils zwei Valenzen in Nachbarstellung zueinander angeordnet sind oder ein zwei über eine Brückengruppe Y (vgl. unten) miteinander verbundene bivalente aromatische Reste enthaltender Rest, d.h. ein insgesamt tetravalenter Rest, bei dem jeweils zwei Valenzen in Nachbarstellung zueinander angeordnet sind; weist der Rest Q mehrere aromatische und/oder heterocyclische Strukturelemente auf, so befinden sich die Valenzpaare jeweils an endständigen derartigen Strukturelementen;
- B¹ =: -O-, -NR⁴-, vorzugsweise -NH- oder ein bivalenter Rest, wie z.B. -S- -SO₂-,
- B² =: -NH-CO-NH-, -NH-CO-O-, -NH-CO- oder eine Einfachbindung,
- R² =: ein bivalenter aliphatischer oder aromatischer Rest, beispielsweise Hexamethylen, Ethylen, Phenylen, Toluylen oder eine Einfachbindung,
- R³ =: ein bivalenter aliphatischer, cycloaliphatischer, aromatischer oder heterocyclischer Rest, beispielsweise Diphenylen, Phenylen, Methyldicyclohexylen, Methyldiphenylen, Oxydiphenylen, Tetraisopropyldiphenylen, wobei diese Reste auch halogensubstituiert sein können,
- R¹ =: ein leicht wasserstoffabgebender Rest aus der Gruppe: Isoalkyle, mit 3 bis 15 Kohlenstoffatomen, wie z.B. Isopropyl, Isobutyl, Ethylhexyl, Aminoisoalkyle mit 3 bis 15 Kohlenstoffatomen, wie z.B. Diisopropylaminoethyl, Isopropylaminoalkyl, N-Isobutyl- oder N-Isopropyl-aminoalkyl, Cycloisoalkyle mit 6 bis 15 Kohlenstoffatomen, beispielsweise Methylcyclohexyl, ein oder mehrere Heteroatome enthaltende Cycloisoalkyle, oder mit Isoalkyl, Aminoisoalkyl oder Cycloisoalkyl substituierte aromatische Reste, wie z.B. Furfuryl-, Tetrahydrofurfuryl-, Benzyl-, Cumyl-, p-Menthyl-, Terpin-, Thymolreste, oder Gruppierungen folgender Formeln

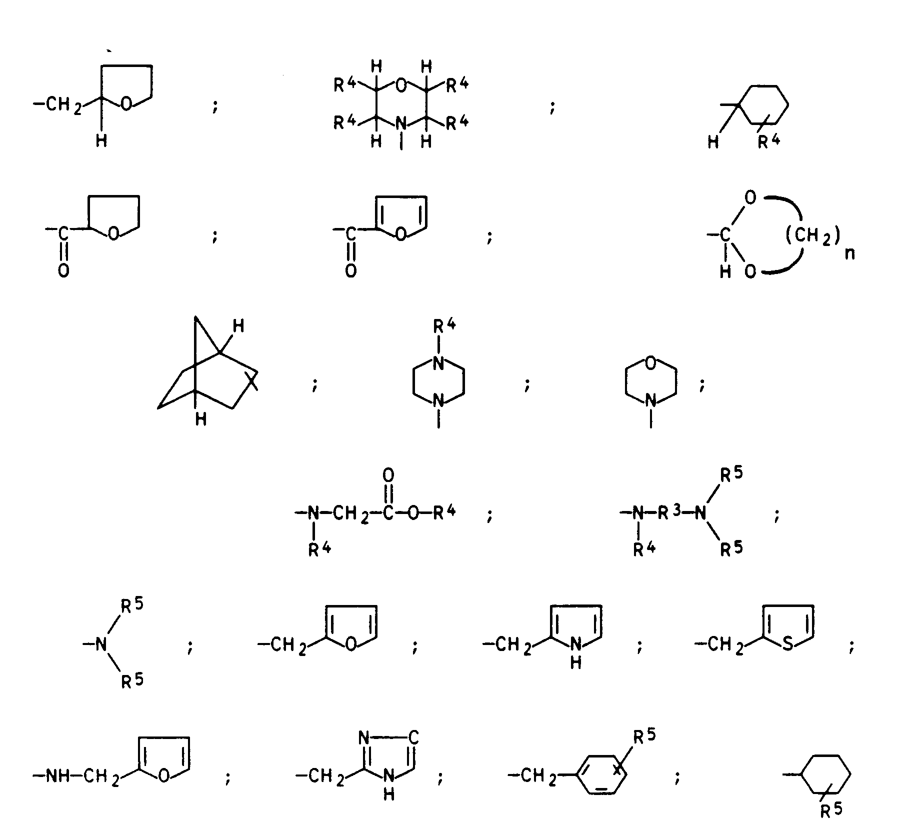

worin n = 2 oder 3,
- R⁴ =: H, geradkettiges Alkyl mit 1 bis 15 Kohlenstoffatomen, verzweigtes Alkyl mit 3 bis 15 Kohlenstoffatomen, durch Halogen, wie z.B. Cl, F, Br substituiertes geradkettiges oder verzweigtes Alkyl, wie z.B. -C(CF₃)₂ oder Isopropyl,
- R⁵ =: Alkyl mit 1 bis 15 Kohlenstoffatomen, wie z.B. Isopropyl, Isobutyl oder Isoamyl, Aryl, wie z.B. Isoamylphenyl, durch Halogen, wie z.B. Cl, F oder Br substituiertes Alkyl mit 1 bis 15 Kohlenstoffatomen, durch Halogen, wie z.B. Cl oder F, Br, substituiertes Aryl.

Beispiele für Vorstufen (a) der allgemeinen Formel (I) sind: 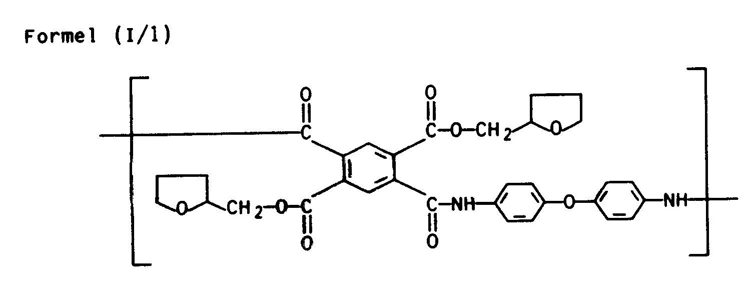
- Q:: Pyromellitsäurerest,
- R³:: Diaminodiphenyloxidrest,
- B¹:: -O-,
- R²:: Einfachbindung
- B²:: Einfachbindung
- R¹:: Tetrahydrofurfurylrest,
- A:: Einfachbindung,

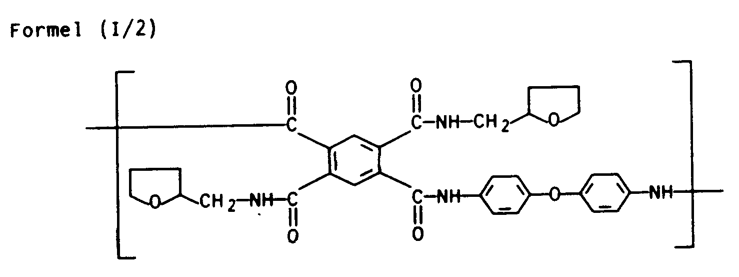

- Q:: Pyromellitsäurerest,
- R³:: Diaminodiphenyloxidrest,
- B¹:: -NH-,
- R²:: Einfachbindung
- B²:: Einfachbindung
- R¹:: Tetrahydrofurfurylrest,
- A:: Einfachbindung,

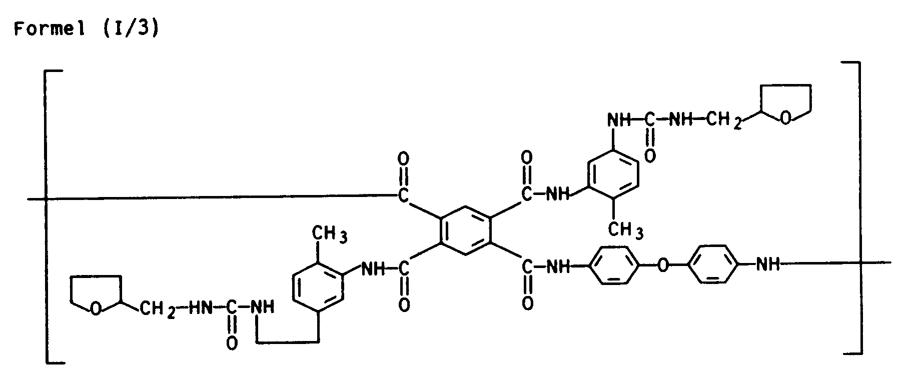

- Q:: Pyromellitsäurerest,
- R³:: Diaminodiphenyloxidrest,
- B¹:: -NH-,
- R²:: Toluylen-,
- B²:: -NH-CO-NH-,
- R¹:: Tetrahydrofurfurylrest,
- A:: Einfachbindung,

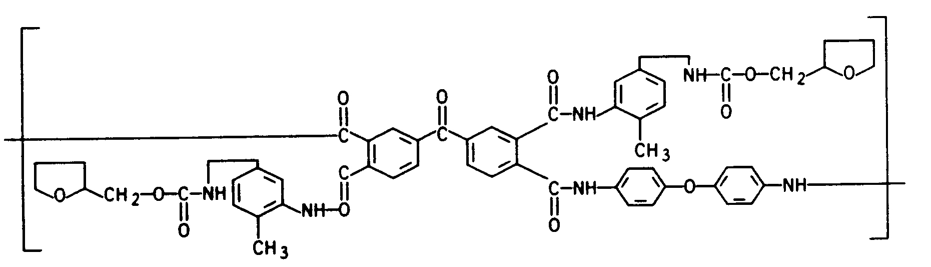

- Q:: Benzophenontetracarbonsäurerest,
- R³:: Diaminodiphenyloxidrest,
- B¹:: -NH-,
- R²:: Toluylen-,
- B²:: -NH-CO-O-,
- R¹:: Tetrahydrofurfurylrest,
- A:: Einfachbindung,

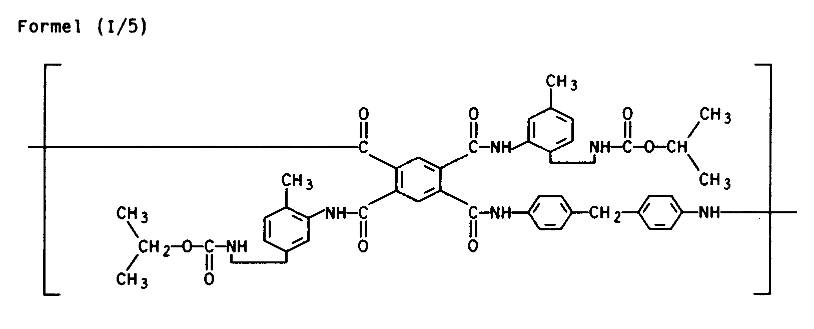

- Q:: Pyromellitsäurerest,
- R³:: Diaminodiphenylmethanrest,
- B¹:: -NH-,
- R²:: Toluylen-,
- B²:: -NH-CO-O-,
- R¹:: Isopropylrest,
- A:: Einfachbindung

Vorstufen (a) der Formeln (I/1) bis (I/5) führen bei Behandlung mit höheren Temperaturen, im allgemeinen ≧150°C zu Polyimiden als Stoffe der Stufe (C). 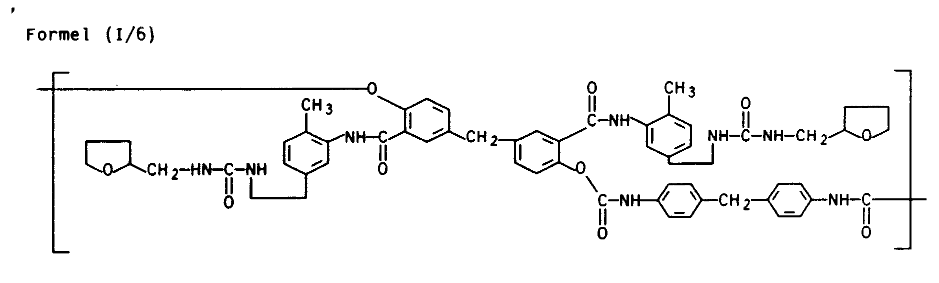
- Q:: 3,3′-Dicarboxyl-4,4′-dihydroxydiphenylmethanrest,
- R³:: basiert auf 4,4′-Diisocyanato-diphenylmethanrest,
- B¹:: -NH-,
- R²:: Toluylen-,
- B²:: -NH-CO-NH-,
- R¹:: Tetrahydrofurfurylrest,
- A:: -O-

Vorstufen (a) der Formel (I/6) führen bei Behandlung mit höheren Temperaturen, in der Regel ≧150°C, zu Polybenzoxazindione als Stoffe der Stufe (C).

Die Vorstufen (a) der Formeln (I/1) bis (I/6) können beispielsweise Polymerisationsgrade zwischen 2 und 200 aufweisen.

Für den tetravalenten Rest Q in der allgemeinen Formel (I) kommen beispielsweise folgende in Frage, ohne die beanspruchten Strukturen auf solche mit diesen Strukturgliedern zu beschränken. 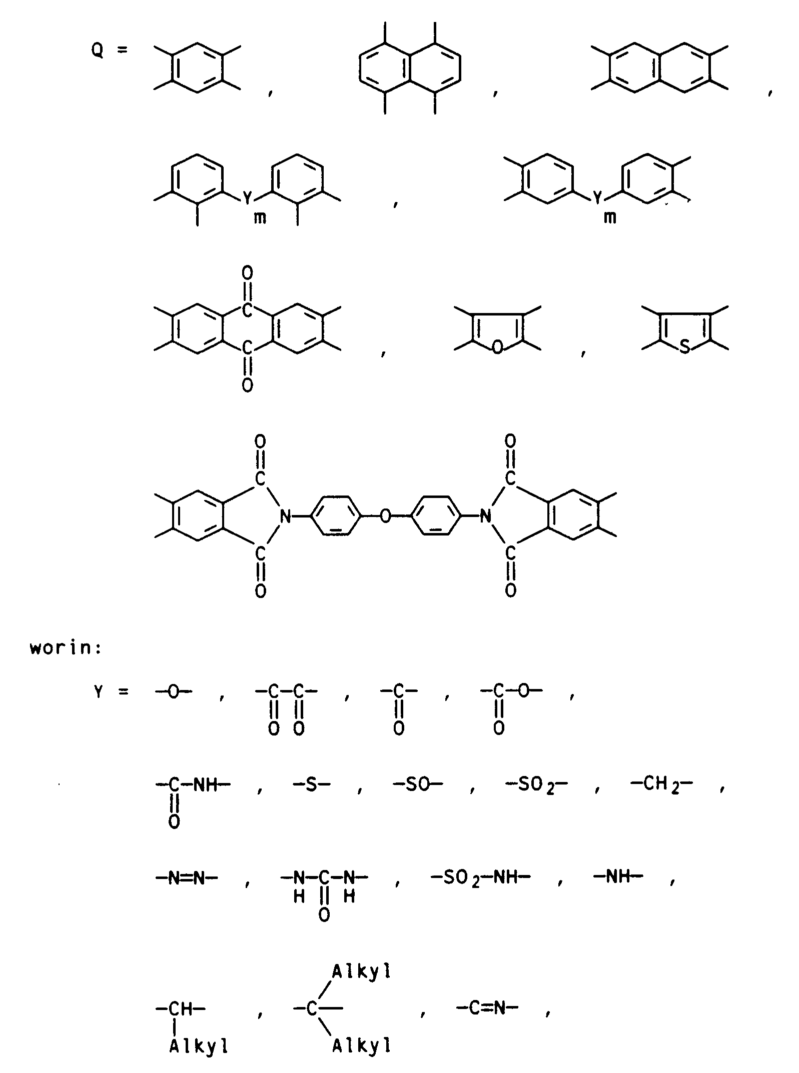
m = 0 oder 1;
Alkyl = Alkylgruppen mit jeweils 1 bis 15 Kohlenstoffatomen sein können.

Die Methoden zum Aufbau der erfindungsgemäßen oligomeren und/oder polymeren Vorstufen (a) sind im Prinzip Stand der Technik.

Grundsätzlich lassen sich zwei Wege benutzen:
1. Einführung der lichtempfindlichen Gruppe in die Monomerbausteine und danach Aufbau der höhermolekularen Vorstufen.
   Ein typisches Beispiel für diesen Weg wird in der DE-A-24 37 397 angegeben, nämlich die Addition von Allylalkohol an Pyromellitsäureanhydrid, Umsetzung des entstandenen Halbesters mit Thionylchlorid zum Säurechlorid und aus diesem Aufbau der Polymeren mit Diaminen.
   Weitere Schriften zum Stand der Technik, in denen Aufbauwege von ungesättigten monomeren Bausteinen ausgehend beschrieben werden, sind z.B. DE-A-24 37 369, DE-A-24 37 413, DE-A-29 19 840, DE-A-29 19 841, DE-A-34 11 660, DE-A-34 11 697, DE-A-34 11 706, DE-A-34 11 714, US-A-4 551 522 und US-A-4 558 117.
2. Ein anderer Weg zur Einführung lichtempfindlicher ungesättigter Gruppen besteht darin, zunächst polymere bzw. oligomere Produkte ohne lichtempfindliche Gruppen aufzubauen und in diese dann lichtempfindlich Gruppen einzuführen.
   Ein typisches Beispiel für diesen Weg wird z.B. in der DE 29 33 826 beschrieben: Es werden Pyromellithsäureanhydrid und Diaminodiphenyloxid, in Dimethylacetamid als Lösemittel, zu einem Polyamid addiert das Carboxylgruppen enthält. An diesen Carboxylgruppen werden dann mit Glycidylmethacrylat Doppelbindungen eingeführt, wodurch Vorprodukte gebildet werden, die in Gegenwart von Photoinititatoren unter UV-Licht vernetzbar sind.
   Weitere Schriften zum Stand der Technik, in welchen die nachträgliche Einführung von lichtempfindlichen Gruppen in polymere Vorprodukte beschrieben werden, sind z.B. DE-A-29 33 827 und DE-A-30 21 748.

Erfindungsgemäß werden an sich bekannte polymere und/oder oligomere Vorstufen (a) für Polyimide, Polyisoindolochinazolindionen, Polyoxazindionen, Polychinazolindione und verwandte Polyheterocyclen einer Strahlenvernetzung dadurch zugänglich gemacht, daß in diese, auf an sich bekannte Weise, als lichtempfindliche Gruppe wirkende Reste R¹ eingeführt werden.

Die erfindungsgemäßen Vorstufen (a), die lichtempfindliche Reste R¹ tragen, werden in Kombination mit Carbonylverbindungen, die im durch UV-Licht angeregtem Zustand zur Wasserstoffabstraktion befähigt sind, angewandt.

Lichtempfindliche Reste R¹ im Sinne der vorliegenden Erfindung sind solche, die ein leicht zu abstrahierendes Wasserstoffatom besitzen und aliphatisch, cycloaliphatisch, aromatisch, aliphatisch/aromatische sein können und Heteroatome besitzen können, wie sie oben bereits genannt sind.

Der Aufbau der polymeren und/oder oligomeren, carboxylgruppenhaltigen Reste R¹ tragenden Vorstufen (a) geht im allgemeinen von Polycarbonsäuren und/oder Polycarbonsäureanhydriden, Polyhydroxypolycarbonsäuren, Polyaminopolycarbonsäuren, bevorzugt von Tetracarbonsäuren bzw. Tetracarbonsäuredianhydriden aus, die in der Formel (I) den Rest Q bilden.

Abgeleitet von diesem Rest Q weisen die Endprodukte (C) bevorzugt folgende Struktureinheiten auf: 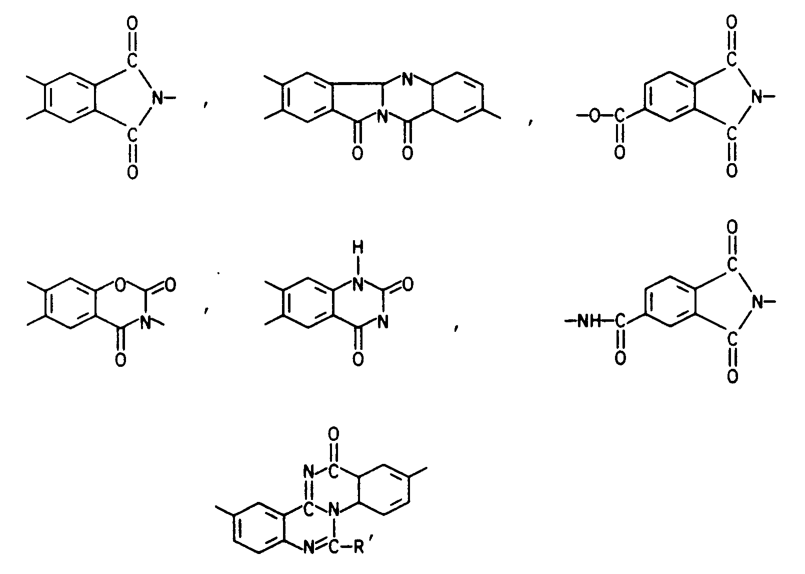
(R′ = Alkyl mit 1 bis 6 Kohlenstoffatomen oder H)
Beispiele für Polycarbonsäuren, von denen der Rest Q aus der Formel (I) abgeleitet werden kann, sind z.B. die folgenden Säuren bzw. deren Anhydride: 2,3,9,10-Perylentetracarbonsäure, 1,4,5,8-Naphthalintetracarbonsäure, 2,6-Dichlornaphthalin-1,4,5,8-tetracarbonsäure, 2,7-Dichlornaphthalin-1,4,5,8-tetracarbonsäure, Phenanthren-1,8,9,10-tetracarbonsäure, Pyromellithsäure, Trimellithsäure, 3,3′,4,4′-Biphenyltetracarbonsäure, 2,2′,4,4′-Biphenyltetracarbonsäure, 4,4′-Isopropylidendiphthalsäure, 3,3′-Propylidendiphthalsäure, 4,4′-Oxydiphthalsäure, 4,4′-Sulfonyldiphthalsäure, 3,3′-Oxydiphthalsäure,Dicarboxydihydroxydiphenylmethanisomere, Diaminodicarboxydiphenylmethanisomere, Dicarboxydihydroxyphenyloxidisomere, Diaminodicarboxydiphenyloxidisomere, Dicarboxydihydroxydiphenylsulfonisomere, Diaminodicarboxydiphenylsulfoxidisomere, 4,4′-Methylendiphthalsäure, 4,4′-Thiodiphthalsäure, 4,4′-Acetylidendiphthalsäure, 2,3,6,7-Naphthalintetracarbonsäure, 1,2,4,5-Naphthalintetracarbonsäure, 1,2,3,5-Naphthalintetracarbonsäure, Benzol-1,2,3,4-tetracarbobsäure, Thiophen-2,3,4,5-tetracarbonsäure, 1-(3′,4′-Dicarboxyphenyl)-1,3,3-trimethylindan-5,6-dicarbonsäure, 1-(3′,4′-Dicarboxyphenyl)-1,3,3-trimethylindan-6,7-dicarbonsäure, Pyrazin-2,3,5,6-tetracarbonsäure, Tetrahydrofurantetracarbonsäure, Benzophenontetracarbonsäure sowie Substitutionsprodukte dieser Polycarbonsäuren, insbesondere Halogen- und/oder Alkylsubstitutionsprodukte.

Zur Einführung des Reste R³ in die Vorprodukte (a) kann von Diaminen oder Diisocyanaten ausgegangen werden.

Geeignete Diamine sind z.B. 4,4′-Diaminodiphenylether,4,4′-Methylenbis-(o-chloranilin), 3,3′-Dichlorbenzidin, 3,3′-Sulfonyldianilin, 4,4′-Diaminobenzophenon, 1,5-Diaminonaphthalin, Bis-(4-aminophenyl)-dimethylsilan, Bis-(4-aminophenyl)-diethylsilan, Bis-(4-aminophenyl)-diphenylsilan, Bis-(4-aminophenyloxy)-dimethylsilan, Bis-(4-aminophenyl)-ethylphosphinoxid, N-(Bis-(4-aminophenyl))-N-methylamin, N-(Bis-(4-aminophenyl))-N-phenylamin,4,4′-Methylenbis-(3-methylanilin), 4,4′-Methylenbis-(2-ethylanilin), 4,4′-Methylenbis-(2-methoxyanilin), 5,5′-Methylenbis-(2-aminophenol), 4,4′-Methylenbis-(2-methylanilin), 5,5′-Oxybis-(2-aminophenol), 4,4′-Thiobis-(2-methylanilin), 4,4′-Thiobis-(2-methoxyanilin), 4,4′-Thiobis-(2-chloranilin), 4,4′-Sulfonylbis-(2-ethoxyanilin), 4,4′-Sulfonylbis-(2-chloranilin), 5,5′-Sulfonylbis-(2-aminophenol), 3,3′-Dimethyl-4,4′-diaminobenzophenon, 3,3′-Dimethoxy-4,4′-diaminobenzophenon, 3,3′-Dichlor-4,4′-diaminobenzophenon, 4,4′-Diaminobiphenyl, m-Phenylendiamin, p-Phenylendiamin, 4,4′-Methylendianilin, 4,4′-Oxydianilin, 4,4′-Thiodianilin, 4,4′-Sulfonyldianilin, 4,4′-Isopropylidendianilin, 3,3′-Dimethylbenzidin, 3,3′-Dimethoxybenzidin, 3,3′-Dicarboxybenzidin, Diaminotoluol.

Der Begriff "Diamine" soll dabei auch Verbindungen umfassen, die das Strukturelement >N-N< enthalten, d.h. Abkömmlinge des Hydrazins.

Geeignete Diisocyanate sind z.B. Toluylendiisocyanat, Isophorondiisocyanat, Diisocyanatodiphenylmethan, Trimethyl-hexamethylendiisocyanat, Hexamethylendiisocyanat, Dicyclohexylmethandiisocyanat und die über Uretdiongruppen aufgebauten Dimere dieser Isocyanate, weiter monomere, oligomere und/oder polymere Diisocyanate, die aus der Reaktion von mit Isocyanatgruppen bifunktionellen Verbindungen, z.B. Diaminen oder Diolen mit Diisocyanaten erhalten werden.

Diese Ausgangsstoffe sind bekannt oder können nach an sich bekannten Verfahren hergestellt werden.

Es werden bevorzugt solche Vorprodukte (a) aufgebaut, die nach der Überführung in den Endzustand (C) eine hohe Temperaturbeständigkeit aufweisen.

Der Aufbau der polymeren Vorstufen (a) erfolgt in geeigneten organischen Lösemitteln, das sind bevorzugt Formamid, Acetamid, N-Methylformamid, N,N-Dimethylformamid, N-Methylpyrrolidon, N,N-Dimethylacetamid, Butyrolacton, Caprolactam, Hexamethylphosphorsäuretrisamid u.a.

Die Herstellung der erfindungsgemäßen Vorstufen (a) kann analog den oben für die Einführung von Doppelbindungen unter 1. beschriebenen Weg erfolgen oder bevorzugt nach dem unter 2. beschrieben Weg. Dabei werden aromatische und/oder heterocyclische Tetracarbonsäureanhydride mit Diaminoverbindungen und/oder Diaminoverbindungen mit wenigstens einer orthoständigen Amidogruppe bzw. aromatische und/oder heterocyclische Dihydroxydicarbonsäuren und/oder Diaminodicarbonsäuren mit Diisocyanaten zu carboxylgruppenhaltigen Polyadditionsprodukten umgesetzt.

In diese carboxylgruppenhaltigen Polyadditionsprodukte werden die, in Kombination mit bestimmten Carbonylverbindungen lichtempfindlichen Reste R¹ in der Weise eingeführt, daß Rest R¹ mit Amin- oder Hydroxygruppen über Amid-, bzw. Estergruppen nach bekannten Methoden der organischen Chemie verknüpft werden.

Weiter ist es möglich, Reste R¹, die Epoxid- oder Isocyanatgruppen tragen, mit den carboxylgruppenhaltigen Polyadditionsprodukten zu den erfindungsgemäßen Vorprodukten (a) umzusetzen.

Als Carbonylverbindungen (b), die im durch UV-Strahlung angeregten Zustand zur Wasserstoffabstraktion befähigt sind, eignen sich bevorzugt aromatische Ketone, wie Benzophenon, Xanthon, Thioxanthon, Fluorenon, Benzil, Acenaphthenchinon, Tetralon, Benzylidenaceton, Dibenzyliden, Benzoin, Benzoinether, Naphthochinon, Anthrachinon, Anthron und die aus diesen Grund-körpern, z.B. durch Halogenierung oder Alkylierung, abgeleiteten Carbonylverbindungen sowie aromatisch/aliphatische Ketone wie Acetophenon und Propiophenon.

Besonders bevorzugt sind Benzophenon und Benzophenonderivate, allein oder im Gemisch, wie z.B. 2-, 3- und 4-Hydroxibenzophenon, Benzophenon-2-carbonsäure, Benzophenon-3-carbonsäure, Benzophenon-4-carbonsäure, 3,3′,4,4′-Benzophenontetracarbonsäure und deren Anhydrid, 3,3′,4,4′-Tetra-(tert.-butylperoxycarbonyl)-benzophenon, 2-, 3- und 4-Phenylbenzophenon, 2-, 3- und 4-Alkylbenzophenone mit 1 bis 10 C-Atomen im Alkylrest, halogenierte (Monoalkyl)benzophenone, wie 4-(Trifluormethyl)benzophenon. Geeignet sind auch Heterocerdianthron und dessen Endoperoxid. Weiter geeignet sind Ketone wie 2-Acetonaphthon, 4-Aminobenzophenon sowie 4,4′-Tetramethylaminobenzophenon und die Salze dieser Amine. Weiter lassen sich auch aliphatische Ketone wie Aceton, Methylisobutylketon, Isoamylketon und Copolymerisate von Kohlenmonoxid mit Ethylen verwenden.

Mit Vorteil lassen sich auch Gemische derartiger Carbonylverbindungen einsetzen.

Die Carbonylverbindung (b) wird dabei im allgemeinen in Mengen von 0,001 bis 200, bevorzugt 1 bis 10 Gew.%, bezogen auf die Vorstufen (a), angewandt. Die Carbonylverbindungen können in fester, gelöster, dispergierter oder geschmolzener monomerer und/oder polymerer Form angewandt werden.

Die vorteilhaft einzusetzende Menge der Carbonylverbindung wird u.a. bestimmt von der gewünschten Auftragsdicke, dem Polymerisationsgrad der Vorstufe (a), dem chemischen Aufbau der Vorstufe (a) und dem Spektrum der verwendeten UV-Strahlenquelle.

Weiter ist es möglich, z.B. zur Verbesserung der Lichtempfindlichkeit und/oder zur Anpassung der Absorption an eine UV-Strahlenquelle, zusätzlich nichtcarbonylische Photoinitiatoren, Sensibilisatoren und/oder bestimmte Farbstoffe bzw. Leukofarbstoffe zuzugeben.

Die Auswahl geeigneter weiterer Sensibilisatoren, Photoinititatoren und/oder Farbstoffe erfolgt in üblicher Weise nach dem Stand der Technik. Weiter übliche Hilfs- und Zusatzstoffe, insbesondere Verlaufsverbesserer und Haftvermittler können ebenfalls zugesetzt werden.

Wichtigster Verwendungszweck der erfindungsgemäßen Produkte sind Photoresists, wobei nach Belichtung unter einer Maske, mit geeigneten Lösemitteln eine Strukturierung erfolgt und die strukturierten Schichten dann unter Anwendung höherer Temperaturen in die Endfunktionsschicht (C) überführt werden.

Aber auch andere Verwendungen als Isolier- und Schutzschichten in der Elektrotechnik, Elektronik und Mikroelektronik sind möglich, wobei die erfindungsgemäßen Stoffe in den Stufen (B) und (C) eingesetzt werden können.

Weiter können die erfindungsgemäßen Stoffe vorteilhaft für Überzüge auf Lichtleiterfasern verwendet werden.

Anhand der Ausführungsbeispiele soll die Erfindung näher erläutert werden.

Die in den folgenden Beispielen genannten Teile und Prozente sind, soweit nicht anders angegeben, Gewichtsteile und Gewichtsprozente.

### 1. Herstellung eines Carboxylgruppenhaltigen Polyadditionsproduktes:

109 Teile Pyromellitsäureanhydrid (0,5 Mol) und
486 Teile N-Methylpyrrolidon
werden bei 60°C unter Rühren in einem Reaktionskolben, der Druckausgleich über ein mit Trockenmittel gefülltes U-Rohr hat, unter reinstem Stickstoff gelöst.

Über einen Tropftrichter wird eine Lösung von
100 Teilen Diaminodiphenyloxid (0,5 Mol) in
350 Teilen N-Methylpyrrolidon
in einer Stunde zugegeben. Die Temperatur steigt dabei auf 66°C an. Es wird eine Stunde bei 75°C gerührt und dann abgekühlt. Es resultiert eine viskose Harzlösung.

### Charakterisierung:

- SZ: : 53,2;
- Viskosität: : 5750 mPas bei D = 100 l/s
- IR-Spektrum: : typische Amidbandenkombination bei 1720, 1663, 1543, 1500 und 1240 l/cm.

### 2. Herstellung eines Isocyanats mit Resten R¹:

174 Teile 2,4-Toluylendiisocyanat (1 Mol = 2 Äquivalent)
werden unter Rühren mit einer Lösung von
72 Teilen Tetrahydrofurfurylalkohol (1 Mol = 1 Äquivalent)
0,1 Teilen Dibutylzinndilaurat
0,1 Teilen Benzoylchlorid in
127 Teilen n-Butylacetat
in zwei Stunden tropfenweise versetzt, die Temperatur steigt dabei von 23°C auf 39°C. Es wird noch zwei Stunden bei 35°C nachgerührt. Es resultiert eine niederviskose Flüssigkeit mit einem NCO-Gehalt von 10,8 %.

### Beispiel 1

200 Teile des carboxylgruppenhaltigen Polyadditionsproduktes (vgl. unter 1.) und
0,3 Teile Dimethylaminopyridin
werden unter Rühren in einem Glaskolben mit aufgesetztem Blasenzähler rasch mit
76 Teilen des Isocyanats mit Resten R¹ (vgl. unter 2.)
versetzt. Es setzt eine Gasentwicklung ein, die nach etwa zwei Stunden nachläßt. Es wird zwei Stunden bei 60°C weitergerührt, wobei die Gasentwicklung zunächst wieder stärker wird und dann aufhört. Diese Harzlösung wird mit und ohne Zusatz von 2 % Benzophenon geprüft (vgl. Tabelle).

### Beispiel 2

218 Teile Pyromellitsäureanhydrid (1 Mol)
werden in einem Rührkolben mit einem stöchiometrischen Überschuß, nämlich
900 Teilen Tetrahydrofurfurylalkohol und
1 Teil Triethylendiamin
fünf Stunden bei 65°C gerührt. Dann wird im Vakuum der Überschuß von Tetrahydrofurfurylalkohol weitgehend abdestilliert. Es resultiert nach Masse des Rückstandes (365 g) und Säurezahl (314) Pyromellithsäureditetrahydrofurfurylester. Dann werden unter Rühren und Wasserausschluß in einer Stunde
600 Teile thionylchlorid zugegeben, wobei die Temperatur auf 38°C ansteigt. Nach zwei Stunden wird für vier Stunden auf 60°C erwärmt und dann im Vakuum überschüssiges Thionylchlorid abdestilliert. Der Rückstand wird mit
100 Teilen Dimethylacetamid
versetzt und unter Eiskühlung eine Lösung von
200 Teilen 4,4′-Diaminodiphenyloxid in
600 Teilen Dimethylacetamid
in zwei Stunden bei 22 bis 27°C zugegeben und zwei Stunden bei 40°C nachgerührt. Es resultiert eine niederviskose braune Harzlösung. Diese wird unter starkem Rühren in eine Mischung aus gleichen Teilen von Propanol/Aceton/Wasser einlaufen lassen. Dabei bildet sich eine bräunliche Dispersion, aus der sich nach 48 Stunden ein braunes Harz abscheidet. Die überstehende, immer noch trübe Dispersion wird verworfen und der Rückstand zweimal mit frischem Fällungslösemittel aufgerührt, wobei nach mehrstündigem Stehen Dispersionen über sedimentiertem Harz erhalten werden.

Die Dispersionsschichten werden verworfen. Es resultieren
184 Teile braunes, zähflüssiges Harz, das in
184 Teilen N-Methylpyrrolidon
gelöst und zu Entfernung von Restfeuchtigkeit über Molekularsieb aufbewahrt wird.

Diese Harzlösung wird mit und ohne Zusatz von 2 % Benzophenon geprüft (vgl. Tabelle).

### Beispiel 3

200 Teile carboxylgruppenhaltiges Polyadditionsprodukt (vgl. unter 1.)
werden in einem Rührkolben innerhalb von 15 Minuten mit einer Lösung von
18,6 Teilen Tetrahydrofurfurylamin in
43,4 Teilen N-Methylpyrrolidon
versetzt. Dabei steigt die Temperatur auf 34°C. Es wird weiter innerhalb von 30 Minuten eine Lösung von
39,6 Teilen Dicyclohexylcarbodiimid in
92,4 Teilen N-Methylpyrrolidon
zugegeben. Dabei steigt die Temperatur auf 38°C und es bildet sich ein Niederschlag.

Dann wird noch eine Stunde bis 60°C weitergerührt, abgekühlt und vom Niederschlag abfiltriert.

Es resultiert eine bräunliche Harzlösung mit einer Viskosität von 870 mPas bei D = 100. Diese Harzlösung wird mit und ohne Zusatz von 2 % Benzophenon geprüft (vgl. Tabelle).

Prüfung der Produkte gemäß den Beispielen und Vergleichsbeispiel:
Harzlösungen des carboxylgruppenhaltigen Polyadditionsproduktes (vgl. unter 1.) sowie nach den Beispielen 1, 2 und 3 werden tel quel und mit 2 % Benzophenon, bezogen auf den Harzgehalt, auf Glasplatten aufgerakelt und bei 50°C im Vakuum 3 Stunden getrocknet, Es werden klebfreie hellbräunliche Filme von 25 bis 30 µm Dicke erhalten. Diese werden zur Hälfte mit Aluminiumfolie abgedeckt und unter Quecksilberhochdrucklampen 15 Minuten belichtet und dann mit einer Mischung aus Ethanol/N-Methylpyrrolidon 1:1, auf Unterschiede der Löslichkeit zwischen bestrahlten und abgedeckten Stellen geprüft.

Die Prüfbefunde zeigt die folgende Tabelle

| Harz | Benzophenon | Löslichkeit | |
|---|---|---|---|
| | | unbelichtet | belichtet |
| carboxylgruppenhaltiges Polyadditionsprodukt (vgl. unter 1.) | - | löslich | löslich |
| | + | löslich | löslich |
| Beispiel 1 | - | löslich | löslich |
| | + | löslich | unlöslich |
| Beispiel 2 | - | löslich | löslich |
| | + | löslich | unlöslich |
| Beispiel 3 | - | löslich | löslich |
| | + | löslich | unlöslich |
| löslich bedeutet : läßt sich mit einem lösemittelgetränkten Wattebausch mit leichtem Reiben entfernen. unlöslich bedeutet : läßt sich mit einem lösemittelgetränkten Wattebausch nicht oder nur nach längerem starken Reiben als bröselig vernetztes Harz entfernen. | | | |

## Patentansprüche

1. Strahlungsempfindliches, zur Herstellung von Polyimiden, Polyisoindolochinazolindionen, Polyoxazindionen, Polychinazolindionen oder Polychinazolonen geeignetes Gemisch, das bei Bestrahlung mit aktinischem Licht eine Löslichkeitsdifferenzierung erfährt, dadurch gekennzeichnet, daß das strahlungsempfindliche Gemisch besteht aus
(a) einer oder mehreren Vorstufen, die Strukturelemente der allgemeinen Formel (I) aufweisen 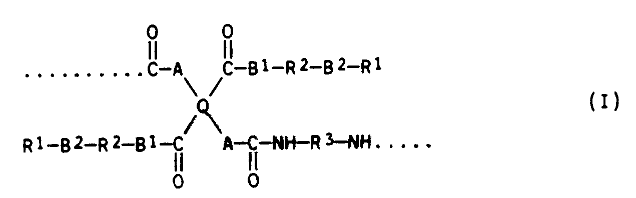 worin
A = -O-, -NH- oder eine Einfachbindung,
Q = ein aromatischer oder heterocyclischer tetravalenter Rest oder ein zwei über eine Brückengruppe miteinander verbundene bivalente aromatische Reste enthaltender Rest, in dem jeweils zwei der Valenzen in Nachbarstellung zueinander angeordnet sind,
B¹ = -O- oder -NR⁴-,
B² = -NH-CO-NH-, -NH-CO-O-, -NH-CO- oder eine Einfachbindung,
R¹ = ein leicht wasserstoffabgebender Rest,
R² = ein bivalenter aliphatischer oder aromatischer Rest oder eine Einfachbindung,
R³ = ein bivalenter aliphatischer, cycloaliphatischer, aromatischer oder heterocyclischer Rest, der gegebenenfalls halogensubstituiert ist,
R⁴ = H, geradkettiges oder verzweigtes Alkyl, das halogensubstituiert sein kann,
mit der Maßgabe, daß der leicht wasserstoffabgebende Rest R¹ ein Rest aus der Gruppe Isoalkyle, Aminoisoalkyle, Cycloisoalkyle, Cycloisoalkyle mit einem oder mehreren Heteroatomen, oder Gruppierungen folgender allgemeiner Formeln ausgewählt ist 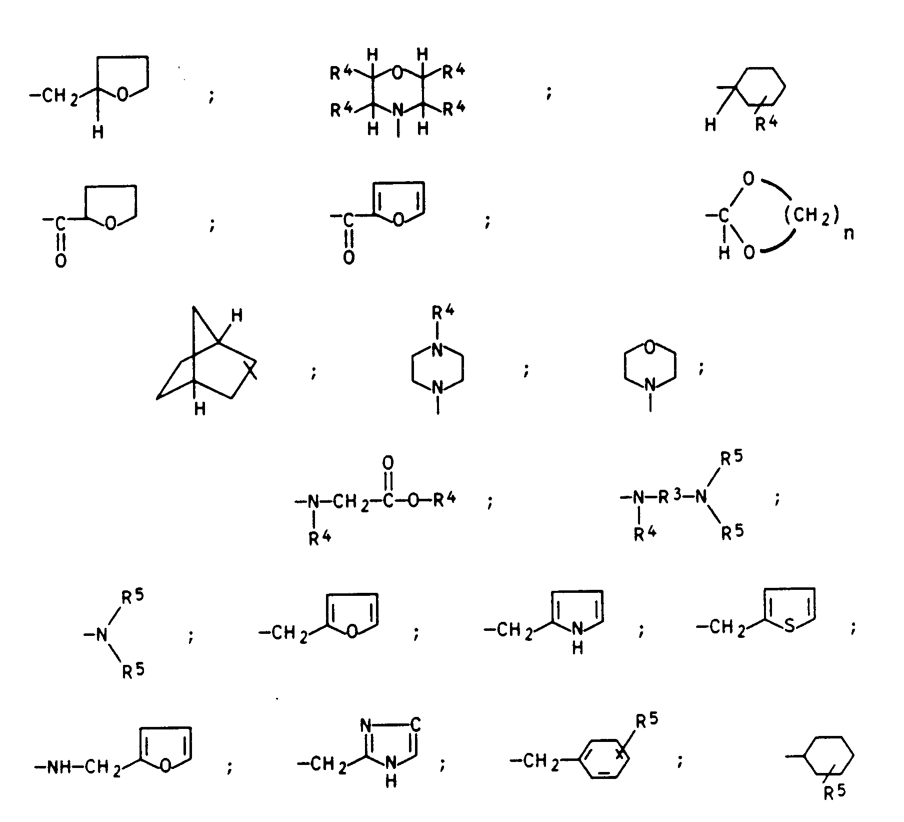 worin n = 2 oder 3,
und
R⁵ = Alkyl, Aryl, halogensubstituiertes Alkyl, halogen-substituiertes Aryl oder Isoamylphenyl
(b) einer oder mehreren aromatische Reste enthaltenden Carbonylverbindungen, die im durch UV-Strahlung angeregten Zustand zur Wasserstoffabstraktion befähigt sind, sowie gegebenenfalls
(c) einem oder mehreren Stoffen aus der Gruppe Photoinitiator, Photosensibilisator, (Leuko)Farbstoff und aliphatisches Keton.
wobei die löslichkeitsdifferenzierung nach folgender Methode bestimmt wird:
Harzlösungen des carboxylgruppenhaltigen Polyadditionsproduktes werden tel quel und mit 2% Benzophenon, bezogen auf den Harzgehalt, auf Glasplatten aufgerakelt und bei 50°C im Vakuum 3 Stunden getrocknet. Es werden klebfreie Filme von 25 bis 30 µm Dicke erhalten. Diese werden zur Hälfte mit Aluminiumfolie abgedeckt und unter Quecksilberhochdrucklampen 15 Minuten belichtet und auf Unterschiede der löslichkeit zwischen bestrahlten und abgedeckten Stellen geprüft.
Die löslichkeitsdifferenzierung ist dann gegeben, wenn das Produkt sich an unbelichteten Stellen mit einem lösungsmittelgetränkten Wattebausch (einer Mischung aus Ethanol/N-Methylpyrrolidon 1:1) mit leichtem Reiben entfernen läßt, während es sich an belichteten Stellen mit einem lösemittelgetränkten Wattebausch nicht oder nur nach längerem starken Reiben als bröselig vernetztes Harz entfernen läßt.

2. Strahlungsempfindliches Gemisch nach Anspruch 1, dadurch gekennzeichnet, daß als aromatische Reste enthaltende Carbonylverbindung (b) mindestens ein aromatisches Keton aus der Gruppe Benzophenon, Xanthon, Thioxanthon, Fluorenon, Benzil, Acenaphthenchinon, Tetralon, Benzylidenaceton, Dibenzylidenacetophenon, Benzoin, Benzoinether, Benzanilid, Acetophenon, Propiophenon, Naphthochinon, Anthrachinon, Anthron, 2-, 3- und 4-Hydroxibenzophenon, Benzophenon-2-carbonsäure, Benzophenon-3-carbonsäure, Benzophenon-4-carbonsäure, 3,3′,4,4′-Benzophenontetracarbonsäure und deren Anhydrid, 3,3′,4,4′-Tetra-(tert.-butylperoxycarbonyl)-benzophenon, 2-, 3- und 4-Phenylbenzophenon, 2-, 3- und 4-Alkylbenzophenone mit 1 bis 10 C-Atomen im Alkylrest, halogeniertes (Monoalkyl)benzophenon und 4-(Trifluormethyl)-benzophenon eingesetzt wird.

3. Strahlungsempfindliches Gemisch nach Anspruch 1, dadurch gekennzeichnet, daß als Carbonylverbindungen (b) Heterocerdianthron, dessen Endoperoxid, Ketone aus der Gruppe 2-Acetonaphthon, 4-Aminobenzophenon, Michlers Keton und/oder den Salzen dieser Amine eingesetzt werden.

4. Strahlungsempfindliches Gemisch nach einem der Ansprüche 1 bis 3, dadurch gekennzeichnet, daß die Carbonylverbindung (b) in einer Menge von 0,001 bis 200 Gew.%, bezogen auf die Vorstufe (a) eingesetzt wird.

5. Strahlungsempfindliches Gemisch nach einem der Ansprüche 1 bis 4, dadurch gekennzeichnet, daß die Carbonylverbindungen (b) in fester, gelöster, dispergierter oder geschmolzener, monomerer und/oder polymerer Form eingesetzt werden.

6. Strahlungsempfindliches Gemisch nach einem der vorhergehenden Ansprüche, dadurch gekennzeichnet, daß die Vorstufen (a) in monomerer, oligomerer oder polymerer Form oder in Mischungen verschiedener Polymerisationsstufen eingesetzt werden.

7. Strahlungsempfindliches Gemisch nach einem der vorhergehenden Ansprüche, dadurch gekennzeichnet, daß als Vorstufen (a) solche eingesetzt werden, die durch Verknüpfung carboxylgruppenhaltiger Polyadditionsprodukte aus aromatischen und/oder heterocyclischen Tetracarbonsäureanhydriden und Diaminoverbindungen an den Carboxylgruppen mit Resten R¹ über eine Ester-, Ether-, Amid- oder Urethangruppe erhalten worden sind.

8. Strahlungsempfindliches Gemisch nach einem der Ansprüche 1 bis 6, dadurch gekennzeichnet, daß als Vorstufen (a) solche eingesetzt werden, die durch Verknüpfung carboxylgruppenhaltiger Polyadditionsprodukte aus aromatischen und/oder heterocyclischen Dihydroxydicarbonsäuren und Diisocyanaten an den Carboxylgruppen mit Resten R¹ über eine Ester-, Ether-, Amid- oder Urethangruppe erhalten worden sind.

9. Strahlungsempfindliches Gemisch nach einem der Ansprüche 1 bis 6, dadurch gekennzeichnet, daß als Vorstufen (a) solche eingesetzt werden, die durch Verknüpfung carboxylgruppenhaltiger Polyadditionsprodukte aus aromatischen und/oder heterocyclischen Diaminodicarbonsäuren und Diisocyanaten an den Carboxylgruppen mit Resten R¹ über eine Ester-, Ether-, Amid- oder Urethangruppe erhalten worden sind.

10. Verfahren zur Herstellung von strahlungsempfindlichen Gemischen nach einem der vorhergehenden Ansprüche, dadurch gekennzeichnet, daß zur Einführung der Reste R¹ in die Vorstufen (a), carboxylgruppenhaltige Polyadditionsprodukte aus aromatischen und/oder heterocyclischen Diaminodicarbonsäuren und Diisocyanaten und/oder carboxylgruppenhaltige Polyadditionsprodukte aus aromatischen und/oder heterocyclischen Dihydroxydicarbonsäuren und Diisocyanaten und/oder carboxylgruppenhaltige Polyadditionsprodukte aus aromatischen und/oder heterocyclischen Tetracarbonsäureanhydriden und Diaminoverbindungen, mit Monoaddukten von Diisocyanaten mit Verbindungen der Struktur R¹-OH, R¹-NH₂, R¹-(B²)-NH₂ und/oder R¹-COOH umgesetzt werden.

11. Verfahren nach Anspruch 10, dadurch gekennzeichnet, daß in die carboxylgruppenhaltigen Polyadditionsprodukte aus aromatischen und/oder heterocyclischen Diaminodicarbonsäuren und Diisocyanaten und/oder carboxylgruppenhaltigen Polyadditionsprodukte aus aromatischen und/oder heterocyclischen Dihydroxydicarbonsäuren und Diisocyanaten und/oder carboxylgruppenhaltigen Polyadditionsprodukte aus aromatischen und/oder heterocyclischen Tetracarbonsäureanhydriden und Diaminoverbindungen, die Reste R¹ in einer solchen Menge eingeführt werden, daß das Verhältnis der Reste R¹ zu den Carboxylgruppen der carboxylgruppenhaltigen Polyadditionsprodukte 1:1 bis 0,05:1 beträgt.

12. Verfahren nach einem der Ansprüche 10 oder 11, dadurch gekennzeichnet, daß als Tetracarbonsäureanhydrid Pyromellitsäureanhydrid und/oder Benzophenontetracarbonsäureanhydrid eingesetzt werden.

13. Verfahren nach einem der Ansprüche 10 oder 11, dadurch gekennzeichnet, daß als Dihydroxidicarbonsäure 4,4′-Dihydroxydiphenylmethan-3,3′-dicarbonsäure eingesetzt wird.

14. Verfahren nach einem der Ansprüche 10 oder 11, dadurch gekennzeichnet, daß als Diaminodicarbonsäure 4,4′-Diaminodiphenylmethan-3,3′-dicarbonsäure eingesetzt wird.

15. Strahlungsempfindliche Gemische nach einem der Ansprüche 1 bis 9, dadurch gekennzeichnet, daß die Vorstufen (a) nicht ausschließlich über die Reste R¹ vernetzbar sind, sondern zusätzlich weitere, strahlungsempfindliche Reste enthalten, insbesondere Reste mit ethylenischen Doppelbindungen und/oder Reste, die mit Bisaziden vernetzen.

16. Strahlungsempfindliche Gemische nach einem der Ansprüche 1 bis 9, dadurch gekennzeichnet, daß sie Kombinationen unterschiedlicher Reste R¹ enthalten.

17. Strahlungsempfindliche Gemische nach einem der Ansprüche 1 bis 9, 15 oder 16, dadurch gekennzeichnet, daß die strahlungsempfindlichen Gemische zusätzlich andere strahlungsempfindliche Stoffe und/oder nicht strahlungsempfindliche Stoffe enthalten.

18. Verwendung der strahlungsempfindlichen Gemische nach einem der Ansprüche 1 bis 9 oder 15 bis 16 zur Erzeugung schützender und isolierender Schichten für die Anwendung beim Aufbau gedruckter Schaltungen und integrierter Schaltkreise, wobei sie einer Strahlenvernetzung und/oder thermischen Nachbehandlung unterzogen werden.

19. Verwendung der strahlungsempfindlichen Gemische nach einem der Ansprüche 1 bis 9 oder 15 bis 17 zur Erzeugung schützender und isolierender Schichten für die Anwendung beim Aufbau gedruckter Schaltungen und integrierter Schaltkreise, wobei sie unter einer Maske belichtet und dadurch partiell strahlenvernetzt, danach mit geeigneten Lösemitteln strukturiert und dann gegebenenfalls einer thermischen Nachbehandlung unterzogen werden.

20. Verwendung der strahlungsempfindlichen Gemische nach einem der Ansprüche 1 bis 9 oder 15 bis 17 für Lacke, Einbettungsmaterialien und Überzugsmittel.

## Claims

1. A radiation-sensitive mixture which is suitable for preparing a polyimide, a polyisoindoloquinazolinedione, a polyoxazinedione, a polyquinazolinedione or a polyquinazolone and which on irradiation with actinic light undergoes solubility differentiation, consisting of
(a) one or more precursors having structural elements of the general formula (I) 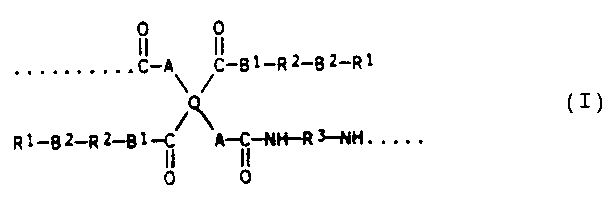 where
A is -O-, -NH- or a single bond,
Q is an aromatic or heterocyclic tetravalent radical, or a radical which contains two bivalent aromatic radicals linked by a bridging group, wherein two at a time of the valences are adjacent to each other,
B¹ is -O- or -NR⁴-,
B² is -NH-CO-NH-, -NH-CO-O-, -NH-CO- or a single bond,
R¹ is a readily hydrogen-donating radical
R² is a bivalent aliphatic or aromatic radical or a single bond,
R³ is a bivalent aliphatic, cycloaliphatic, aromatic or heterocyclic radical which may be halogen-substituted and
R⁴ is H or straight-chain or branched alkyl which may be halogen-substituted,
with the proviso that the readily hydrogen-donating radical R¹ is a radical selected from the group consisting of isoalkyls, aminoisoalkyls, cycloisoalkyls, cycloisoalkyls having one or more hetero atoms, and groups of the following general formulae: 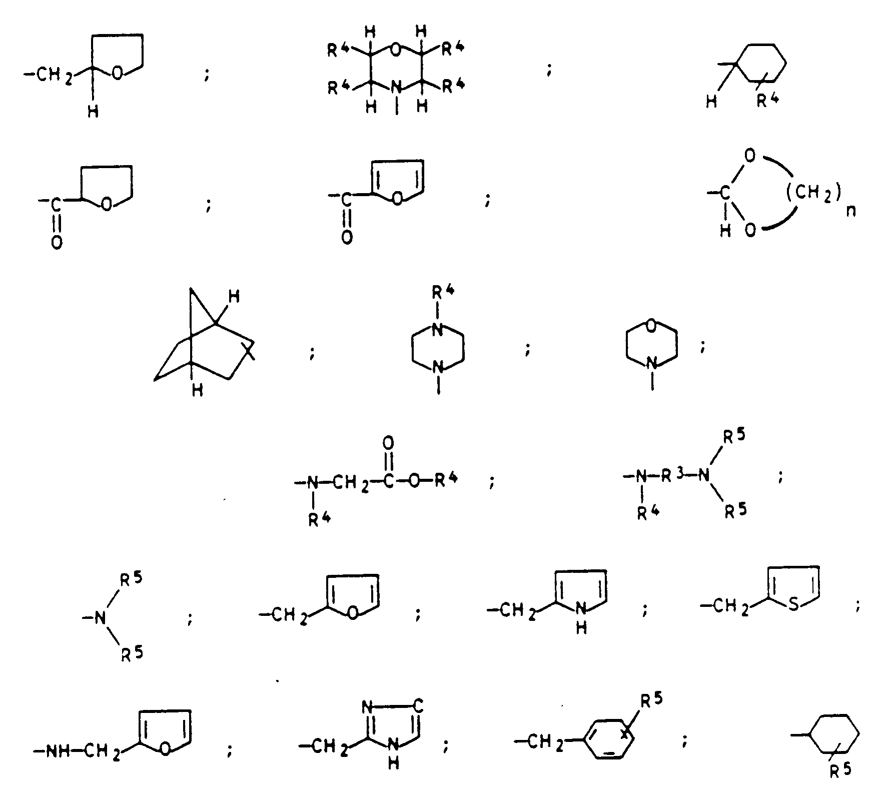 where
n = 2 or 3 and
R⁵ is alkyl, aryl, halogen-substituted alkyl, halogen-substituted aryl or isoamylphenyl,
(b) one or more aryl-containing carbonyl compounds which when excited by UV radiation are capable of hydrogen abstraction, and optionally
(c) one or more substances selected from the group consisting of a photoinitiator, a photosensitizer, a (leuco)dye and an aliphatic ketone, the solubility difference being determined by the following method:
Resin solutions of the carboxyl-containing polyadduct, tel quel and with 2%, based on the resin content, of benzophenone, are applied to glass sheets with a doctor blade and are dried at 50°C under reduced pressure for 3 hours. Nontacky films from 25 to 30 µm thick are obtained. These are half covered with aluminium foil and exposed to high pressure mercury lampo for 15 minutes, and a test is carried out to determine differences between the solubility of the exposed part and that of the covered part.
There is a solubility difference if the product can be removed from unexposed parts by gentle rubbing with a solvent-impregnated cottonwool pad (a 1:1 ethanol/N-methylpyrrolidone mixture), whereas it cannot be removed from exposed parts with a solvent-impregnated cottonwool pad or can be removed as a crumbly crosslinked resin only after prolonged vigorous rubbing.

2. A radiation-sensitive mixture as claimed in claim 1, wherein the aryl-containing carbonyl compound (b) used comprises one or more aromatic ketones from the group consisting of benzophenone, xanthone, thioxanthone, fluorenone, benzil, acenaphthenequinone, tetralone, benzylideneacetone, dibenzylideneacetophenone, benzoin, benzoin ether, benzanilide, acetophenone, propiophenone, naphthoquinone, anthraquinone, anthrone, 2-, 3- and 4-hydroxybenzophenone, benzophenone-2-carboxylic acid, benzophenone-3-carboxylic acid, benzophenone-4-carboxylic acid, 3,3',4,4'-benzophenonetetracarboxylic acid and anhydride, 3,3',4,4'-tetra(tert.-butylperoxycarbonyl)benzophenone, 2-, 3-, and 4-phenylbenzophenone, 2-, 3- and 4-alkylbenzophenones having from 1 to 10 carbon atoms in the alkyl radical, halogenated (monoalkyl)benzophenone and 4-(trifluoromethyl)benzophenone.

3. A radiation-sensitive mixture as claimed in claim 1, wherein carbonyl compound (b) comprises heteroceriumdianthrone, its endoperoxide, a ketone from a group consisting of 2-acetonaphthone, 4-aminobenzophenone, Michler's ketone and the salts of these amines.

4. A radiation-sensitive mixture as claimed in any of claims 1 to 3, wherein carbonyl compound (b) is used in an amount of from 0.001 to 200% by weight, based on precursor (a).

5. A radiation-sensitive mixture as claimed in any of claims 1 to 4, wherein carbonyl compound (b) is used in a solid, dissolved, dispersed or molten, monomeric or polymeric form.

6. A radiation-sensitive mixture as claimed in any of the preceding claims, wherein precursor (a) is used in a monomeric, oligomeric or polymeric form or in the form of a mixture of different polymerization stages.

7. A radiation-sensitive mixture as claimed in any of the preceding claims, wherein precursor (a) has been obtained by linking a carboxyl-containing polyaddition product of an aromatic or heterocyclic tetracarboxylic anhydride and a diamino compound at the carboxyl groups to radicals R¹ via an ester, ether, amide or urethane group.

8. A radiation-sensitive mixture as claimed in any of claims 1 to 6, wherein precursor (a) has been obtained by linking a carboxyl-containing polyaddition product of an aromatic or heterocyclic dihydroxydicarboxylic acid and diisocyanate at the carboxyl groups to radicals R¹ via an ester, ether, amide or urethane group.

9. A radiation-sensitive mixture as claimed in any of claims 1 to 6, wherein precursor (a) has been obtained by linking a carboxyl-containing polyaddition product of an aromatic or heterocyclic diaminodicarboxylic acid and a diisocyanate at the carboxyl groups to radicals R¹ via an ester, ether, amide or urethane group.

10. A process for preparing a radiation-sensitive mixture as claimed in any of the preceding claims, which comprises introducing a radical R¹ into a precursor (a) by reacting a carboxyl-containing polyaddition product of an aromatic or heterocyclic diaminodicarboxylic acid and a diisocyanate, or a carboxyl-containing polyaddition product of an aromatic or heterocyclic dihydroxydicarboxylic acid and diisocyanate, or a carboxyl-containing polyaddition product of an aromatic or heterocyclic tetracarboxylic anhydride and a diamino compound with a mono adduct of a diisocyanate and a compound of the structure R¹-OH, R¹-NH₂, R¹-B²-NH₂ or R¹-COOH.

11. A process as claimed in claim 10, wherein the radicals R¹ are introduced into a carboxyl-containing polyaddition product of an aromatic or heterocyclic diaminodicarboxylic acid and diisocyanate or into a carboxyl-containing polyaddition product of an aromatic or heterocyclic dihydroxydicarboxylic acid and diisocyanate or into a carboxyl-containing polyaddition product of an aromatic or heterocyclic tetracarboxylic anhydride and a diamino compound in such an amount that the ratio of R¹ to carboxyl in the carboxyl-containing polyaddition product is 1:1 to 0.05:1.

12. A process as claimed in claim 10 or 11, wherein the tetracarboxylic anhydride used is pyromellitic anhydride or benzophenonetetracarboxylic anhydride.

13. A process as claimed in claim 10 or 11, wherein the dihydroxydicarboxylic acid used is 4,4'-dihydroxydiphenylmethane-3,3'-dicarboxylic acid.

14. A process as claimed in claim 10 or 11, wherein the diaminodicarboxylic acid used is 4,4'-diaminodiphenylmethane-3,3'-dicarboxylic acid.

15. A radiation-sensitive mixture as claimed in any of claims 1 to 9, wherein precursor (a) is not exclusively crosslinkable via the radicals R¹ but contains further radiation-sensitive radicals, in particular radicals having ethylenic double bonds or other radicals which crosslink with bisazides.

16. A radiation-sensitive mixture as claimed in any of claims 1 to 9, which contains a combination of different radicals R¹.

17. A radiation-sensitive mixture as claimed in any of claims 1 to 9, 15 or 16, which contains in addition other radiation-sensitive substances or non-radiation-sensitive substances.

18. The use of a radiation-sensitive mixture as claimed in any of claims 1 to 9 or 15 or 16 for producing protective and insulating layers for use in the construction of printed and integrated circuits, by subjecting it to radiation crosslinking or thermal aftertreatment.

19. The use of a radiation-sensitive mixture as claimed in any of claims 1 to 9 or 15 to 17 for producing protective and insulating layers for use in the construction of printed and integrated circuits, by exposing it under a mask and thereby partially crosslinking it, then structuring it with a suitable solvent and then if necessary subjecting it to a thermal after-treatment.

20. The use of a radiation-sensitive mixture as claimed in any of claims 1 to 9 or 15 to 17 for paints, embedding materials and coatings.

## Revendications

1. Mélange sensible aux rayonnements, convenant à l'utilisation pour la préparation de polyimides, de polyisoindoloquinazoline-diones, de polyoxazinediones, de Polyquinazoline-diones ou de polyquinazolones, qui subit une modification de solubilité à l'exposition à la lumière actinique, caractérisé en ce qu'il consiste en
(a) un ou plusieurs produits intermédiaires ayant des éléments de structure de formule générale I 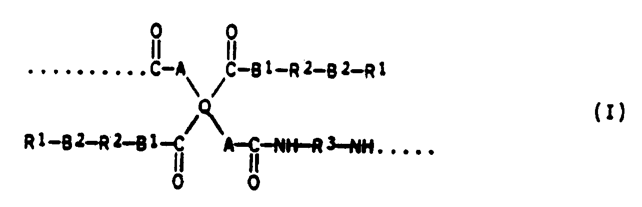 dans laquelle
A = -O-, -NH- ou une liaison simple,
Q = un radical aromatique ou hétérocyclique tétravalent ou un radical contenant deux radicaux aromatiques bivalents reliés entre eux par un pont, dans lequel, dans chaque cas, deux des valences sont dans des positions voisines,
B¹= -O- ou -NR⁴-,
B²= -NH-CO-NH-, -NH-CO-O-, -NH-CO- ou une liaison simple,
R¹= un radical libérant facilement de l'hydrogène,
R²= un radical aliphatique ou aromatique bivalent ou une liaison simple,
R³= un radical bivalent aliphatique, cycloaliphatique, aromatique ou hétérocyclique, éventuellement substitué par des halogènes,
R⁴= H, alkyle à chaîne droite ou ramifiée éventuellement substitué par des halogènes, sous réserve que le radical R¹, libérant facilement de l'hydrogène, est pris parmi les radicaux isoalkyle, aminoisoalkyle, cycloisoalkyle, cycloisoalkyle contenant un ou plusieurs hétéroatomes, ou parmi les groupements de formules générales ci-après : 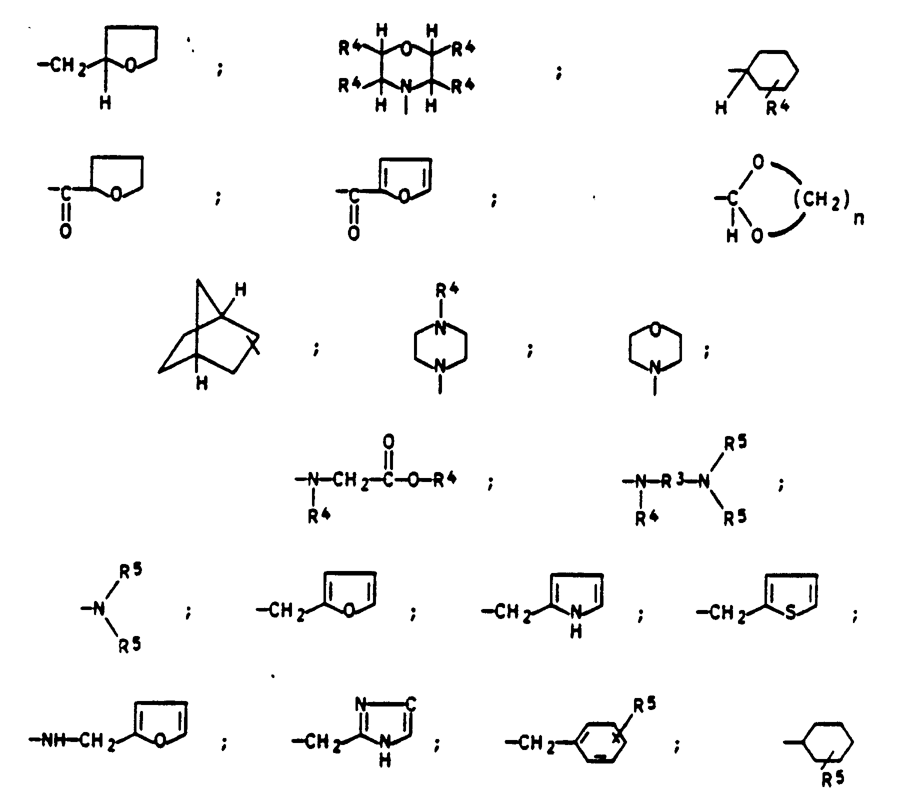
dans lesquelles n = 2 ou 3 et
R⁵= alkyle, aryle, alkyle substitué par des halogènes, aryle substitué par des halogènes ou isoamylphényle,
(b) un ou plusieurs composés carbonylés contenant des radicaux aromatiques et qui, dans l'état excité par des radiations UV, sont capables de soustraire de l'hydrogène et, le cas échéant,
(c) une ou plusieurs substances choisies parmi les photoinducteurs, les photosensibilisants, les colorants (leucos) et les cétones aliphatiques,
la modification de sensibilité étant mise en évidence par le mode opératoire suivant :
on applique par raclage sur des glaces des solutions résineuses du produit de polyaddition contenant des groupes carboxyle, telles quelles et avec 2 % de benzophénone par rapport à la teneur en résine, et on sèche pendant 3 h à 50 degrés C sous vide. On obtient des pellicules non collantes de 25 à 30 µm d'épaisseur. Ces pellicules sont recouvertes sur la moitié d'une feuille d'aluminium et exposées pendant 15 minutes à des lampes à mercure à haute pression, après quoi on examine la différence de solubilité entre les endroits exposés et les endroits masqués.
Il y a différence de solubilité lorsque le produit peut être éliminé aux endroits non exposés par un léger frottement à l'aide d'un tampon d'ouate imprégné de solvant (un mélange éthanol/N-méthylpyrrolidone, 1 : 1) alors qu'aux endroits exposés, le tampon d'ouate imprégné de solvant ne permet pas d'éliminer le produit ou ne l'élimine qu'après frottement vigoureux et prolongé sous forme de miettes de résine réticulée.

2. Mélange sensible aux rayonnements selon la revendication 1, caractérisé en ce qu'il contient, en tant que composé carbonylé contenant des radicaux aromatiques (b), au moins une cétone aromatique prise dans le groupe formé par la benzophénone, la xanthone, la thioxanthone, la fluorénone, l'acénaphtène-quinone, la tétralone, la benzylidèneacétone, la dibenzylidène-acétophénone, la benzoïne, les éthers de la benzoïne, le benzanilide, l'acétophénone, la propiophénone, la naphtoquinone, l'anthraquinone, l'anthrone, la 2-, la 3- et la 4-hydroxybenzophénone, l'acide benzophénone-2-carboxylique, l'acide benzophénone-3-carboxylique, l'acide benzophénone-4-carboxylique, l'acide 3,3',4,4'-benzophénone-tétracarboxylique et son anhydride, la 3,3',4,4'-tétra-(tertbutylperoxycarbonyl)-benzophénone, la 2-, la 3- et la 4-phénylbenzophénone, les 2-, 3- et 4-alkylbenzophénones contenant 1 à 10 atomes de carbone dans le groupe alkyle, les (monoalkyl)benzophénones halogénées et la 4-(trifluorométhyl)-benzophénone.

3. Mélange sensible aux rayonnements selon la revendication 1, caractérisé en ce qu'il contient en tant que composés carbonylés (b), l'hétérocerdianthrone, son endoperoxyde, des cétones prises dans le groupe formé par la 2-acétonaphtone, la 4-aminobenzophénone, la cétone de Michler et/ou de ces amines.

4. Mélange sensible aux rayonnements selon une des revendications 1 à 3, caractérisé en ce que le composé carbonylé (b) est mis en oeuvre en quantité de 0,001 à 200 % en poids par rapport au produit intermédiaire (a).

5. Mélange sensible aux rayonnements selon une des revendications 1 à 4, caractérisé en ce que les composés carbonylés (b) sont mis en oeuvre à l'état solide, à l'état de solution, à l'état de dispersion ou à l'état fondu, sous forme monomère et/ou polymère.

6. Mélange sensible aux rayonnements selon une des revendications qui précèdent, caractérisé en ce que les produits intermédiaires (a) sont mis en oeuvre sous forme monomère, oligomère ou polymère ou à l'état de mélanges de plusieurs stades de polymérisation.

7. Mélange sensible aux rayonnements selon une des revendications qui précèdent, caractérisé en ce que l'on utilise en tant que produits intermédiaires (a) des produits qui ont été obtenus par liaisons de produits de polyaddition, contenant des groupes carboxyle, d'anhydrides d'acides tétracarboxyliques aromatiques et/ou hétérocycliques et de composés diaminés sur les groupes carboxyle avec des radicaux R¹ par l'intermédiaire d'un groupe ester, éther, amide ou uréthanne.

8. Mélange sensible aux rayonnements selon une des revendications 1 à 6, caractérisé en ce que l'on utilise, en tant que produits intermédiaires (a), des produits qui ont été obtenus par liaison de produits de polyaddition, contenant des groupes carboxyle, d'acides dihydroxydicarboxyliques aromatiques et/ou hétérocycliques et de diisocyanates sur les groupes carboxyle avec des radicaux R¹ par l'intermédiaire d'un groupe ester, éther, amide ou uréthanne.

9. Mélange sensible aux rayonnements selon une des revendications 1 à 6, caractérisé en ce que l'on utilise, en tant que produits intermédiaire (a), des produits qui ont été obtenus par liaison de produits de polyaddition, contenant des groupes carboxyle, d'acides diaminodicarboxyliques aromatiques et/ou hétérocycliques et de diisocyanates sur les groupes carboxyle, avec des radicaux R¹ par l'intermédiaire d'un groupe ester, éther, amide ou uréthanne.

10. Procédé de préparation de mélanges sensibles aux rayonnements selon une des revendications qui précèdent, caractérisé en ce que, pour introduire les radicaux R¹ dans les produits intermédiaires (a), on fait réagir des produits de polyaddition, contenant des groupes carboxyle, d'acides diaminodicarboxyliques aromatiques et/ou hétérocycliques et de diisocyanates et/ou des produits de polyaddition, contenant des groupes carboxyle, d'acides dihydroxydicarboxyliques aromatiques et/ou hétérocycliques, et de diisocyanates, et/ou des produits de polyaddition, contenant des groupes carboxyle, d'anhydrides d'acides tétracarboxyliques aromatiques et/ou hétérocycliques et de composés diaminés, avec des mono-adducts de diisocyanates et de composés de structure R¹-OH, R¹-NH₂, R¹-(B²)-NH₂ et/ou R¹-COOH.

11. Procédé selon la revendication 10, caractérisé en ce que, dans les produits de polyaddition, contenant des groupes carboxyle, d'acides diaminodicarboxyliques aromatiques et/ou hétérocycliques et de diisocyanates, et/ou les produits de polyaddition, contenant des groupes carboxyle, d'acides dihydrodicarboxyliques aromatiques et/ou hétérocycliques et de diisocyanates, et/ou les produits de polyaddition, contenant des groupes carboxyle, d'anhydrides d'acides tétracarboxyliques aromatiques et/ou hétérocycliques et de composés diaminés, on introduit les radicaux R¹ en quantités telles que le rapport entre les radicaux R¹ et les groupes carboxyle des produits de polyaddition contenant des groupes carboxyle aille de 1 : 1 à 0,05 : 1.

12. Procédé selon l'une des revendications 10 ou 11, caractérisé en ce que l'on utilise, en tant qu'anhydride d'acide tétracarboxylique, l'anhydride pyromellique et/ou l'anhydride benzophénonetétracarboxylique.

13. Procédé selon une des revendications 10 ou 11, caractérisé en ce que l'on utilise, en tant qu'acide dihydrodicarboxylique, l'acide 4,4'-dihydroxydiphénylméthane-3,3'-dicarboxylique.

14. Procédé selon l'une des revendications 10 ou 11, caractérisé en ce que l'on utilise, en tant qu'acide diaminodicarboxylique, l'acide 4,4'-diaminodiphénylméthane-3,3'-dicarboxylique.

15. Mélanges sensibles aux rayonnements sleon une des revendications 1 à 9, caractérisés en ce que les produits intermédiaires (a) ne sont pas réticulables exclusivement par les radicaux R¹ mais contiennent encore d'autres radicaux sensibles aux rayonnements, en particulier des radicaux à doubles liaisons éthyléniques et/ou des radicaux réticulant avec les bis-azides.

16. Mélanges sensibles aux rayonnements selon une des revendications 1 à 9, caractérisés en ce qu'ils contiennent des combinaisons de divers radicaux R¹.

17. Mélanges sensibles aux rayonnements selon une des revendications 1 à 9, 15 ou 16, caractérisés en ce qu'ils contiennent encore d'autres substances sensibles aux rayonnements et/ou des substances insensibles aux rayonnements.

18. Utilisation des mélanges sensibles aux rayonnements selon une des revendications 1 à 9 ou 15 à 16 pour la production de couches protectrices et isolantes pour l'utilisation à la construction de circuits imprimés et de circuits intégrés, application dans laquelle ils sont soumis à une réticulation sous l'action de rayonnements et/ou à un traitement complémentaire thermique.

19. Utilisation des mélanges sensibles aux rayonnements selon une des revendications 1 à 9 ou 15 à 17 pour la production de couches protectrices et isolantes pour l'utilisation à la construction de circuits intégrés, dans laquelle ils sont exposés à la lumière sous un masque et ainsi partiellement réticulés sous l'action du rayonnement, après quoi ils sont structurés à l'aide de solvants appropriés puis soumis le cas échéant à un traitement complémentaire à la chaleur.

20. Utilisation des mélanges sensibles aux rayonnements selon une des revendications 1 à 9 ou 15 à 17 pour des vernis, des matières d'enrobage et des produits de revêtement.
